Europäisches Patentamt

European Patent Office

Office européen des brevets

(11) Publication number: **0 281 711 B1**

(12) **EUROPEAN PATENT SPECIFICATION**

(45) Date of publication of patent specification: **22.04.92**  (51) Int. Cl.⁵: **G11C 11/412, H01L 27/10**

(21) Application number: **87310856.7**

(22) Date of filing: **10.12.87**

(54) **Four-transistor (4T) static ram cells.**

(30) Priority: **28.01.87 US 8215**

(43) Date of publication of application:
**14.09.88 Bulletin 88/37**

(45) Publication of the grant of the patent:
**22.04.92 Bulletin 92/17**

(84) Designated Contracting States:
**AT BE CH DE ES FR GB GR IT LI LU NL SE**

(56) References cited:
**EP-A- 0 087 979**
**US-A- 4 400 712**
**US-A- 4 554 644**

(73) Proprietor: **ADVANCED MICRO DEVICES, INC.**
**901 Thompson Place P.O. Box 3453**
**Sunnyvale, CA 94088(US)**

(72) Inventor: **Choi, Tat C.**
**759 Folsom Circle**
**Milpitas California 95035(US)**
Inventor: **Klein, Richard K.**
**184A Ada Avenue**
**Mt. View California 94043(US)**
Inventor: **Sander, Craig S.**
**182D Ada Avenue**
**Mt. View California 94043(US)**

(74) Representative: **Sanders, Peter Colin Chris-topher et al**
**BROOKES & MARTIN High Holborn House**
**52/54 High Holborn**
**London WC1V 6SE(GB)**

Rank Xerox (UK) Business Services

## Description

The invention relates to static random access memory (RAM) devices using four-transistor cells.

A conventional four-transistor (4T) RAM cell consists of a two transistor, two resistive-load flip-flop plus two access transistors (known as word-line or pass-gate transistors), such as described in S.M. Sze. VLSI Technology, McGraw-Hill, NY pp. 473-478 (1983). One characteristic of such a cell is that its circuit diagram requires some type of interconnection cross-over. Given a conventional two-polysilicon 4T static RAM process, which uses a single gate polysilicon (gate poly) layer, the requirement for this interconnection cross-over leads to an asymmetrical layout. In addition to the layout area required for the active circuit elements of this cell, this asymmetrical configuration typically requires the use of significant layout area for at least three butting contracts as well as added diffusion and poly-silicon regions for interconnection purposes.

An object of the invention is to provide a four-transistor static RAM cell with improved layout efficiency. A further object is to provide a four-transistor static RAM cell having a symmetrical layout and only two butting contacts; the cell having reduced layout area.

According to the invention there is provided a four-transistor static random access memory cell formed on a semiconductor substrate comprising two pass-gate transistors and a flip-flop with two pull-down transistors, characterised in that the first pass-gate transistor is connected to the first pull-down transistor via a diffusion region, that the second pass-gate transistor is connected to the second pull-down transistor also via a diffusion region, that the one pass-gate/pull-down transistor pair is rotated 180° and arranged adjacent the other pass-gate/pull-down transistor pair, that the gates of the pull-down transistors are formed of a first gate layer, and that the gates of the pass-gate transistors are formed of a second gate layer distinct from the first gate layer.

Further, according to the invention said first pass-gate transistor is connected in series with said first pull-down transistor, with said first pass-gate transistor and said first pull-down transistor sharing a first common node and said second pass-gate transistor is connected in series with said second pull-down transistor, said second pass-gate transistor and said second pull-down transistor sharing a second common node.

The gate layers may be formed from a variety of materials, such as polysilicon or refractory metals, particularly molybdenum or tungsten. Refractory metal silicides, particularly molybdenum, tungsten, titanium and tantalum silicides, can be formed on top of polysilicon to comprise polycide layers. In the embodiment described below, polysilicon will be specified as the gate material, because it is the material most commonly used at present. This should not be construed so as to limit the use of other gate materials.

The use of two separate gate polysilicon depositions allows the use of independent gate oxide thicknesses for the pass-gate and pull-down transistors. Forming gate oxides of separate thickness enables the pull-down transistors to be optimized for higher transconductance, thereby reducing the widths of these devices and saving layout area.

The structure is further characterized by the use of only two butting contacts, one providing an electrical connection between the first common node, a polysilicon segment connected to the gate of the second pull-down transistor and a first resistive load, and the other providing an electrical connection between the second common node, a polysilicon segment connected to the gate of the first pull-down transistor and a second resistive load.

The novel layout of the memory cell is achieved by employing a triple poly process, with two separate gate oxidations and two separate polysilicon depositions for the gates. The third polysilicon deposition is a conventional formation of the load poly, portions of which are appropriately doped to provide both a high-resistance load and a low-resistance interconnect. To maintain cell balance, one of the gate poly depositions is used to form the two pass-gate transistors and the second gate poly deposition is used to form the two pull-down transistors.

While the novel layout reduces cell area and the number of contacts required, further area reduction is achieved by employing a novel reduced area butting contact, which employs a suitably doped, vertically disposed polysilicon plug for electrically interconnecting one or more isolated levels of poly (load poly, gate poly) with a doped silicon region in the substrate. The triple poly cell layout of the invention enjoys a 30 to 40% reduction in cell area over the layout of a conventional double poly memory cell.

In the accompanying drawings, by way of example only:-

FIG. 1 is a schematic diagram of a conventional 4T static RAM cell;

FIG. 2 is a top plan view of an exemplary layout resulting from conventional processing;

FIG. 3 is a top plan view of a layout embodying the invention; and

FIGS. 4a-f depict, in a cross-sectional view taken along the line 4-4 of FIG. 3, the sequence of processing steps to form the layout shown in FIG. 3.

The drawings referred to in this description should be understood as not being drawn to scale except if specifically noted. Moreover, the drawings are intended to illustrate only one portion of an integrated circuit fabricated in accordance with the present invention.

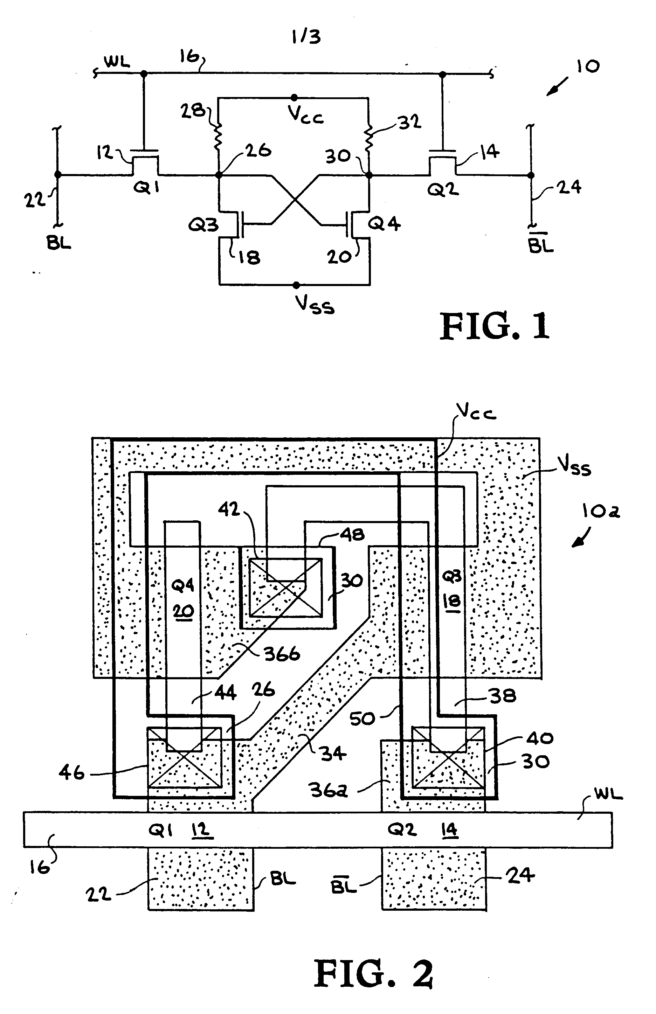

A typical 4T static RAM cell 10 has the circuit diagram shown in FIG. 1. The circuit of the cell 10 comprises two pass-gate transistors Q1 12 and Q2 14, connected to a word-line 16, and a flip-flop comprising two pull-down transistors Q3 18 and Q4 20. Bit-lines 22 and 24 are denoted by BL and $\overline{BL}$, respectively, while word-line 16 is denoted by WL. Transistors 12 and 18 share a common node 26, to which a resistive load 28 and the gate of transistor 20 are connected. Transistors 14 and 20 share a common node 30, to which a resistive load 32 and the gate of transistor 18 are connected.

FIG. 2 shows a conventional layout, denoted generally at 10a, used to achieve the 4T static RAM cell with the circuit diagram 10 shown in FIG. 1. Though other layouts are possible, features and cell sizes are similar to the prior art described here.

In the layout shown in FIG. 2, it will be noted that diffusion region 34 forms a direct connection between pull-down transistor Q3 18 and pass-gate transistor Q1 12, whereas, the diffusion regions 36a, 36b of pass-gate transistor Q2 14 and pull-down transistor Q4 20 are isolated from each other by diffusion region 34 and must be connected using two contacts and an interconnecting segment. In this case the interconnecting segment is a polysilicon segment 38 and the two contacts are butting contacts 40, 42.

Though other layout variations exist, it is a common characteristic of prior-art contemporary 4T static RAM cells that a direct diffusion-region connection between the pass-gate transistors Q1 12 and Q2 14 and the pull-down transistors Q3 18 and Q4 20 is possible for only one of the two pass-gate/pull-down transistor pairs. The diffusion regions of the other pass-gate/pull-down transistor pair are distinct and are, in fact, isolated from each other by the common diffusion region of the first pass-gate/pull-down transistor pair. The fact that both pass-gate/pull-down transistor pairs cannot be connected directly results in the use of substantial layout area for routing and interconnection purposes.

It is also a common characteristic of prior-art 4T static RAM cells that, due to their non-symmetrical layout, the parasitic resistances and capacitances associated with the connection between the pass-gate and pull-down transistors of the two pass-gate/pull-down transistor pairs do not match or balance. In order to maintain cell stability and prevent loss of data during sensing and as a result of these parasitic imbalances, it may be necessary to further increase the size of pull-down transistors over the requirements needed if a symmetrical layout were possible.

To complete the description of the cell layout of FIG. 2, a gate poly 44 interconnects pull-down transistor 20 with diffusion region 34 via a butting contact 46. Each of the butting contacts 40, 42, 46 is covered and overlapped by load polysilicon (load poly) layer segments 48, 50. Elements 16, 38 and 44 are all polysilicon segments formed from the gate polysilicon layer.

It is necessary that a load poly layer segment overlap the butting contact holes 40, 42, 46 by an amount sufficient to ensure complete coverage of the contact holes even under the conditions of worst-case misalignment and other process variations. This overlap is required to prevent the etching of contacted polysilicon segments or diffused regions during the patterning of the load poly layer segments 48, 50. Such etching of these contacted layers could cause the cell to fail.

Reference is now made in detail to a specific embodiment of the present invention, which illustrates the best mode presently contemplated by the inventors for practicing the invention. Alternative embodiments are also briefly described as applicable.

To reduce the cell size, the use of a second independent layer of gate poly is utilized. This requires two separate gate oxidations and two separate polysilicon depositions, instead of the prior art process employing one gate oxidation and one gate poly deposition. In order to maintain cell balance, it is important that the two pass-gate transistors Q1 12 and Q2 14 are made from the same gate poly while the two pull-down transistors Q3 18 20 and Q4 20 are made from the other gate poly.

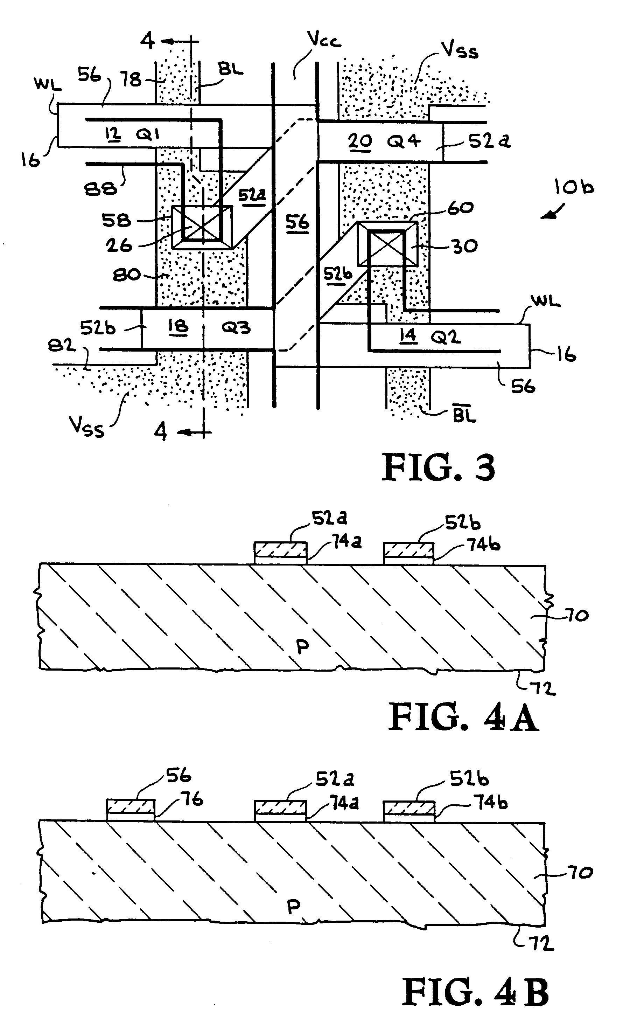

One layout which realizes this is shown in FIG. 3. This layout, denoted generally at 10b, also uses a butt ing contact structure and layout which is different from the conventional butting contact. Details of this butting contact are described below. Use of this new contact structure ties in with the use of two independent gate polysilicon layers to provide a 30 to 40% reduction in cell area.

In the symmetrical layout of FIG. 3, a first pass-gate transistor Q1 12 is adjacent and in series with a first pull-down transistor Q3 18. This pass-gate/pull-down transistor pair shares a first common node 26. A second pass-gate transistor Q2 14 is adjacent and in series with a second pull-down transistor Q4 20 and this pass-gate/pull-down transistor pair shares a second common node 30. These pass-gate/pull-down transistor pairs are placed adjacent each other, with one pair having a 180° rotation relative to the other, thereby achieving a symmetrical layout.

This layout has the added advantage of having the gates of the pull-down transistors 20, 18 lying almost directly adjacent the common node 26, 30, respectively, to which they are to be connected. This arrangement minimizes the length of the first layer polysilicon segments 52a, 52b. The interconnection cross-over is achieved by placing the second-layer polysilicon segment 56 (wordline 16) over the first polysilicon layer segments 52a, 52b. Using this second layer polysilicon segment 56 as the cross-over saves valuable layout area by reducing the number of butting contacts from three to two (58, 60) and by obviating the need for the routing of a diffusion region or first layer polysilicon in order to accomplish a cross-over.

An additional advantage with this cell is that the pull-down transistors 18, 20 can have a different gate oxide thickness than that of the pass-gate transistors 12, 14. This allows the gate oxide thicknesses to be individually optimized, thus saving cell area.

For example, a typical static RAM requires the transconductance ($g_m$) of the pull-down transistors Q3 18, Q4 20 to be two to three times that of the pass-gate transistors Q1 12, Q2 14. This is done to prevent the cell from changing state while being sensed. In a conventional cell, the pass-gate transistors Q1 12, Q2 14 are drawn to minimum dimension while the pull-down transistors 18, 20 have channel widths two to three times larger. Using a process with two gate polys, the pull-down transistors Q3 18, Q4 20 can use thinner gate oxides to increase their transconductances over those of the pass-gate transistors 12, 14. Therefore, the channels do not need to be as wide, and valuable cell layout area can be saved.

The thickness of the gate oxide of the pull-down transistors Q3 18, Q4 20 may range from about 125 to 250 Å, and preferably from about 125 to 150 Å, while the thickness of the gate oxide of the pass-gate transistors Q1 12, Q2 14 may range from about 200 to 400 Å, and preferably from about 200 to 250 Å.

A thinner gate oxide is possible for the pull-down transistors Q3 18 and Q4 20 because significant current flow in these transistors occurs only during sensing. During this instant, the maximum drain voltage is limited by the sensing circuitry to less than about 4 volts. These reduced voltage levels allow the use of a thinner gate oxide while avoiding reliability problems due to hot electron effects. It should be noted that these thinner gate oxide transistors can also be used in other circuitry to improve performance so long as drain voltages are appropriately limited.

The process sequence used to form a two gate poly layout such as shown in FIG. 3 is depicted in FIGS. 4a-f and, except as noted herein, employs conventional NMOS (N-channel metal oxide semiconductor) processes. However, it will be appreciated that other MOS processes, such as PMOS and CMOS, may also be used in the practice of the invention.

The processing sequence described below is directed to the formation of a pass-gate/pull-down transistor pair Q1 12, Q3 18, with butting contact 58 formed therebetween. It will be appreciated that the second pass-gate/pull-down transistor pair Q2 14, Q4 20, with butting contact 60 therebetween, is formed simultaneously therewith. A conventional field oxide (not shown in the processing sequence) separates the two transistor pairs.

P-region 70 is formed in a semiconductor layer 72, such as silicon, lightly doped to about $5 \times 10^{14}$ cm$^{-3}$ (sheet resistivity about 20 Ω-cm). The dopant materials and concentrations and the process used to form the region 70 are well-known and thus do not form a part of this invention.

For the sake of clarity, some processing steps such as forming channel stops are omitted. However, such processing steps, which would normally be employed, may also be employed in the processing sequence herein at the appropriate times; the processing sequence that is described herein is abbreviated and is intended to focus on those steps that result in the desired layout.

Next, a field oxide (not shown) is grown to separate one pass-gate/pull-down transistor pair Q1 12, Q3 18 from the other pair Q2 14, Q4 20. The conditions of the field oxide growth are conventional and well-known.

A first polysilicon gate (poly 1 gate) is formed over gate oxides 74a, 74b and defined to form polysilicon segments 52a, 52b, respectively. The resulting structure is shown in FIG. 4a. Polysilicon segment 52a is formed as a segment of the gate for transistor 20 (not visible in FIGS. 4a-f). Segment 52b is associated with transistor 18.

A second gate oxide 76 is then separately grown. A second polysilicon gate (poly 2 gate) is formed over the gate oxide 76 and defined to form polysilicon segment 56, as shown in FIG. 4b. The polysilicon segment 56 is associated with transistor 12.

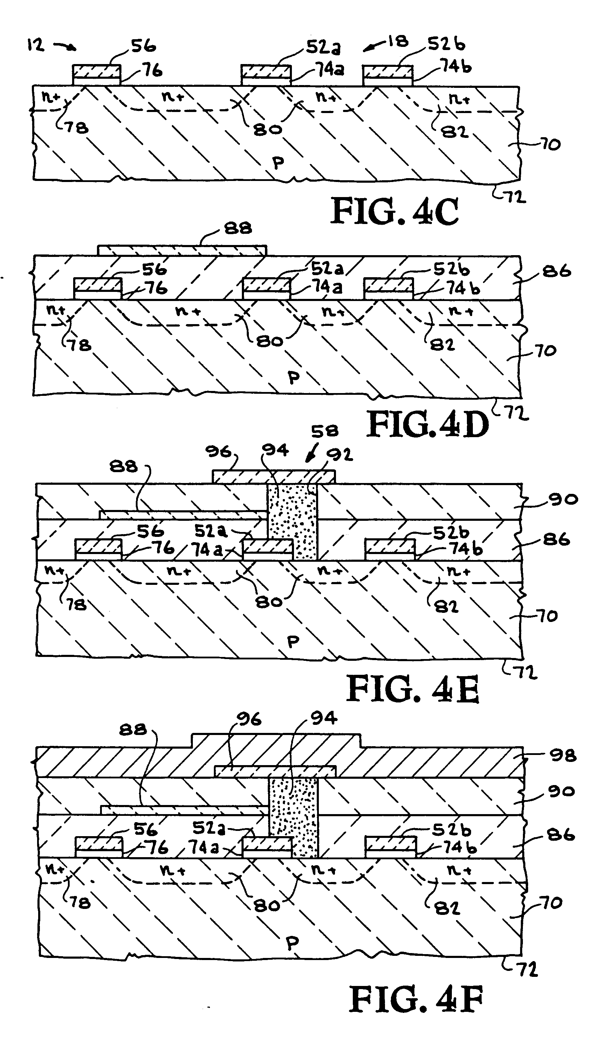

Respective source and drain regions 78, 80, 82 are formed by conventional processing, such as by implantation and diffusion. The resulting structure is depicted in FIG. 4c.

A thick oxide layer 86 is formed to a thickness of about 5,000 Å by conventional processes, and a third polysilicon layer is formed on the oxide layer, and defined to form portion 88, overlying the gates 52a, 56. The poly layer 88 is implanted to the level required to provide a resistive load, typically about 2 to $5 \times 10^{13}$ cm$^{-2}$, having a high sheet resistance of about 20 to $200 \times 10^9$ ohms per square. The structure is shown in FIG. 4d. The poly layer 88 is then defined and masked, and those portions (not shown) employed as connectors are given an additional higher implant dosage to a level of about 1 to $5 \times 10^{15}$ cm$^{-2}$, to provide a lower sheet resistance of about 50 to 1000 ohms per square.

An additional oxide layer 90 is formed over the entire surface and planarized to a thickness of about 5,000 Å, and a contact opening 92 is opened through to the underlying doped region 80. While this process to form reduced area butting contacts is the subject of a separate patent application (A538) filed by the assignee of the present application, briefly, the process employs a two-step anisotropic etch procedure, the first step being non-selective between oxide and polysilicon and the second step being selective to silicon (and polysilicon), etching silicon oxide much faster.

The first etch step is carried out until the contact opening 92 is etched through and beyond the poly layer 88. After etching through the load poly layer 88, the etchant is switched to one that is selective to silicon, etching silicon oxide and stopping at the doped silicon region 80. Where a gate poly 52a is also present, as here, the selective etchant etches past the gate poly, without appreciably etching the gate poly itself.

Next, the opening 92 is filled with polysilicon plug 94, which is appropriately doped (N$^+$ to N$^+$ doped silicon, P$^+$ to P$^+$ doped silicon) to form a conductive link from the buried poly layers 52a, 88 to the doped region 80.

While the plug 94 has been described as comprising doped polysilicon, it will also be appreciated that the plug may comprise other conductive materials which may be conformally deposited. An example of such a material is tungsten.

Openings (not shown) are also formed through the oxide layers 86, 90 to underlying doped areas, in order to make ohmic contact with appropriate portions of the circuit. Such openings may also be advantageously filled with a conformable, conductive material such as described above.

After the plug 94 is formed, an oxide layer 96 is deposited over the plug and defined, so as to permit cross-over of subsequently-deposited metal layer 98 without shorting to the polysilicon plug. The structure is shown in FIG. 4e.

Metal layer 98 is then deposited and defined. Such a metal layer 98 is used to complete the ohmic contact to other portions of the circuit, as appropriate. The structure is depicted in FIG. 4f.

The metal layer 98 may comprise any of the metals compatible with the chemistry of the particular semiconductor and associated insulating compounds. For silicon-based technology, employing silicon oxide insulating materials and doped and undoped polysilicon, the metal layer 98 conveniently comprises an aluminium alloy.

It will be appreciated that use of reduced area butting contacts in conjunction with two separate gate oxide and polysilicon gate layers results in a layout 10b of a memory cell 10 that is considerably smaller than that of the prior art and has fewer butting contacts. Further, due to the symmetry achieved, the cell 10 is more stable to interrogation. Finally, the use of separate gate oxide formations permits independent optimization of pull-down and pass-gate transistors in the cell 10.

Obviously, many modifications and variations of the above-described embodiment will be apparent to those skilled in the art. It is possible that the invention may be practiced in other fabrication technologies in MOS, CMOS or bipolar processes or combinations thereof. Similarly, any process steps described might be interchangeable with other steps in order to achieve the same result.

## Claims

1. A four-transistor static random access memory cell formed on a semiconductor substrate comprising two pass-gate transistors and a flip-flop with two pull-down transistors, the first pass-gate transistor (12) being connected to the first pull-down transistor (18) via a diffusion region (80), characterised in that the second pass-gate transistor (14) is connected to the second pull-down transistor (20) also via a diffusion region, that the one pass-gate/pull-down transistor pair (12,18) is rotated 180° and arranged adjacent the other pass-gate/pull-down transistor pair (14,20), that the gates of the pull-down transistors (18,20) are formed of a first gate layer (52b,52a), and that the gates of the pass-gate transistors (12,14) are formed of a second gate layer (56) distinct from the first gate layer (52b,52a).

2. A memory cell as claimed in Claim 1, characterised in that the gates of said pass-gate transistors (12,14) have a first thickness and the gates of said pull-down transistors (18,20) have a second, independent thickness.

3. A memory cell as claimed in Claim 1 or 2, characterised in that said first pass-gate transistor (12) is connected in series with said first pull-down transistor (18), with said first pass-gate transistor (12) and said first pull-down transistor (18) sharing a first common node (26), and said second pass-gate transistor (14) is connected in series with said second pull-down transistor (20), said second pass-gate transistor (14) and said second pull-down transistor (20) sharing a second common node (30).

4. A memory cell as claimed in Claim 3, characterised in that said gate of said first pull-down transistor (18) is an integral part of a larger first pull-down gate segment (52b), and in that said gate of said second pull-down transistor (20) is an integral part of a larger second pull-down gate segment (52a), with said first pull-down gate segment routed to and positioned over said second common node (30), and with said second pull-down gate segment routed to and positioned over said first common node (26).

5. A memory cell as claimed in Claim 4, characterised in that both of said gates of said pass-gate transistors (12,14) are connected together by a connecting segment (56) comprising the same material used to form said gates of said pass-gate transistors, thereby forming a continuous strip which serves as a wordline (16) and wherein said wordline crosses over said first and second pull-down gate segments (52a,52b).

6. A memory cell as claimed in Claim 5, characterised in that two butting contacts (58,60) are provided, one providing an electrical connection between said first common node (26), said second pull-down gate segment (52a) and a first resistive load (88), and another providing an electrical connection between said second common node (30), said first pull-down gate segment (52b) and a second resistive load.

7. A memory cell as claimed in any one of Claims 1-6, characterised in that said gate layers comprise polysilicon.

8. A memory cell as claimed in any one of Claims 1-6, characterised in that said gate layers comprise a refractory metal.

9. A memory cell as claimed in Claim 8, characterised in that said refractory metal comprises molybdenum or tungsten.

10. A memory cell as claimed in any one of Claims 1-6, characterised in that said gate layers comprise a refractory metal silicide layer formed on top of a polysilicon layer.

11. A memory cell as claimed in Claim 10, characterised in that said refractory metal silicide comprises molybdenum, tungsten, titanium or tantalum silicide.

12. A memory cell as claimed in any one of Claims 1-11, characterised in that said gate oxide thickness of said pull-down transistors ranges from about 125 to 250 Å.

13. A memory cell as claimed in Claim 12, characterised in that said gate oxide thickness ranges from about 125 to 150 Å.

14. A memory cell as claimed in any one of Claims 1-11, characterised in that said gate oxide thickness of said pass-gate transistors ranges from about 200 to 400 Å.

15. A memory cell as claimed in Claim 14, characterised in that said gate oxide thickness ranges from about 200 to 250 Å.

16. A method of fabricating a symmetrical four-transistor static random access memory cell comprising two pass-gate transistors and a flip-flop with two pull-down transistors, the transistors of each pair of transistors comprising a gate overlying a gate oxide formed over a channel region and a pair of doped regions flanking said channel region, a first pass-gate transistor (12) comprising a diffusion region (80) by which connection is made to a first pull-down transistor (18), characterized by forming a second pass-gate transistor (14) comprising a further diffusion region by which connection is made to a second pull-down transistor (20), disposing said first and second pass-gate transistors and said first and second pull-down transistors in a symmetrical layout with the one pass-gate pull-down transistor pair (12,18) rotationally displaced by 180° and arranged adjacent the other pass-gate/pull-down transistor pair (14,20), wherein the gates of the pull-down transistors (18,20) are formed of a first gate layer (52b,52a) and the gates of the pass-gate transistors (12,14) are formed of a second gate layer (50) distinct from the first gate layer (52b,52a).

17. A method as claimed in Claim 16, characterised by forming patterned, appropriately doped, high resistance load regions and low resistance interconnect regions in a polysilicon layer which is distinct from any gate layers.

18. A method as claimed in Claim 17, characterised by forming in one cell two plugs of conductive material, with one plug providing an electrical connection between a first resistive load, a gate segment associated with a second pull-down gate and a first common node shared by a first pull-down transistor and a first pass-gate transistor, and with the other plug providing an electrical connection between a second resistive load, a gate segment associated with a first pull-down gate and a second common node shared by a second pull-down transistor and a second pass-gate transistor.

**19.** A method as claimed in Claim 18, characterised by forming said conductive material essentially of doped polysilicon, doped with the same conductivity type as said doped region, or tungsten.

## Revendications

**1.** Une cellule de mémoire à accès sélectif statique à quatre transistors formée sur un substrat semi-conducteur comportant deux transistors portes d'accès et une bascule avec deux transistors abaisseurs de tension, le premier transistor porte d'accès (12) étant relié au premier transistor abaisseur de tension (18) via une zone de diffusion (80), caractérisée en ce que le second transistor porte d'accès (14) est relié au second transistor abaisseur de tension (20) également via une zone de diffusion, en ce que la paire transistor porte d'accès / transistor abaisseur de tension (12,18) subit une rotation de 180° pour être disposée de manière contiguë à l'autre paire transistor porte d'accès / transistor abaisseur de tension (14,20), en ce que les grilles des transistors abaisseurs de tension (18,20) sont formées d'une première couche de grille (52b, 52a), et en ce que les grilles des transistors portes d'accès (12,14) sont formées d'une seconde couche de grille (56) distincte de la première couche de grille (52b, 52a).

**2.** Une cellule de mémoire selon la Revendication 1, caractérisée en ce que les grilles desdits transistors portes d'accès (12,14) ont une première épaisseur et les grilles desdits transistors abaisseurs de tension (18,20) ont une seconde épaisseur, indépendante.

**3.** Une cellule de mémoire selon la Revendication 1 ou 2, caractérisée en ce que ledit premier transistor porte d'accès (12) est relié en série avec ledit premier transistor abaisseur de tension (18), ledit premier transistor porte d'accès (12) et ledit premier transistor abaisseur de tension (18) partageant un premier noeud commun (26) et ledit second transistor porte d'accès (14) est relié en série avec ledit second transistor abaisseur de tension (20), ledit second transistor porte d'accès (14) et ledit second transistor abaisseur de tension (20) partageant un second noeud commun (30).

**4.** Une cellule de mémoire selon la Revendication 3, caractérisée en ce que ladite grille dudit premier transistor abaisseur de tension (18) est partie intégrante d'un premier segment de grille abaisseur de tension plus grand (520), et en ce que ladite grille dudit second transistor abaisseur de tension (20) est partie intégrante d'un segment de grille abaisseur de tension plus grand (52a), ledit premier segment de grille abaisseur de tension étant tracé vers et positionné par-dessus ledit second noeud commun (30), et ledit second segment de grille abaisseur de tension étant tracé vers et positionné par-dessus ledit premier noeud commun (26).

**5.** Une cellule de mémoire selon la Revendication 4, caractérisée en ce que les deux dites grilles desdits transitors portes d'accès (12,14) sont reliées entre elles par un segment de connexion (56) comportant le même matériau que celui utilisé pour former lesdites grilles desdits transistors portes d'accès, formant ainsi un ruban continu qui sert de ligne de mots (16) et dans lequel ladite ligne de mots enjambe lesdits premier et second segments de grille (52a, 52b).

**6.** Une cellule de mémoire selon la Revendication 5, caractérisée en ce que deux contacts convexes (58,60) sont prévus, l'un assurant une liaison électrique entre ledit premier noeud commun (26), ledit second segment de grille abaisseur de tension (52a) et une première charge ohmique (88), et l'autre assurant une liaison électrique entre ledit second noeud commun (30), ledit premier segment de grille abaisseur de tension (52b) et une seconde charge ohmique.

**7.** Une cellule de mémoire selon l'une quelconque des revendications 1 à 6, caractérisée en ce que lesdites couches de grille comportent du polysilicium.

**8.** Une cellule de mémoire selon l'une quelconque des revendications 1 à 6, caractérisée en ce que lesdites couches de grille comportent un métal réfractaire.

**9.** Une cellule de mémoire selon la revendication 8, caractérisée en ce que ledit métal réfractaire comporte du molybdène ou du tungstène.

**10.** Une cellule de mémoire selon l'une quelconque des revendications 1 à 6, caractérisée en ce que lesdites couches de grille comportent une couche de siliciure de métal réfractaire formée à la surface d'une couche de polysilicium.

11. Une cellule de mémoire selon la revendication 10, caractérisée en ce que ledit siliciure de métal réfractaire comporte du siliciure de molybdène, de tungstène , de titane ou de tantale.

12. Une cellule de mémoire selon l'une quelconque des revendications 1 à 11, caractérisée en ce que ladite épaisseur d'oxyde de grille desdits transistors abaisseurs de tension va d'environ 125 à 250 Å.

13. Une cellule de mémoire selon la revendication 12, caractérisée en ce que ladite épaisseur d'oxyde de grille va d'environ 125 à 150 Å.

14. Une cellule de mémoire selon l'une quelconque des revendications 1 à 11, caractérisée en ce que ladite épaisseur d'oxyde de grille desdits transistors portes d'accès va d'environ 200 à 400 Å.

15. Une cellule de mémoire selon la revendication 14, caractérisée en ce que ladite épaisseur d'oxyde de grille va d'environ 200 à 250 Å.

16. Un procédé de fabrication d'une cellule de mémoire à accès sélectif statique à quatre transistors symétriques comportant deux transistors portes d'accès et une bascule avec deux transistors abaisseurs de tension, les transistors de chaque paire de transistors comportant une grille recouvrant un oxyde de grille formé par dessus une zone de canaux et deux zones dopées encadrant ladite zone de canaux , une premier transistor porte d'accès (12) comportant une zone de diffusion (80) par laquelle se fait la liaison vers un premier transistor abaisseur de tension (18), caractérisé en ce qu'on forme un second transistor porte d'accès (14) comportant une autre zone de diffusion par laquelle se fait la liaison vers un second transistor abaisseur de tension (20), on dispose lesdits premier et second transistors portes d'accès et lesdits premier et second transistors abaisseurs de tension selon une implantation symétrique où l'une des paires transistor porte d'accès / transistor abaisseur de tension (12,18) est par rotation déplacée de 180° et disposée de manière contiguë à l'autre paire transistor porte d'accès / transistor abaisseur de tension (14,20), les grilles des transistors abaisseurs de tension (18,20) étant formées d'une première couche de grille (52b,52a) et les grilles des transistors portes d'accès (12,14) étant formées d'une seconde couche de grille (50) distincte de la première couche de grille (52b, 52a).

17. Un procédé selon la revendication 16, caractérisé par la formation, en une couche de polysilicium distincte de toute couche de grille, de zones d'interconnexions à faible résistance et de zones de charge à résistance élevée, dopées de façon appropriées et configurées.

18. Un procédé selon la revendication 17, caractérisé par la formation en une cellule de deux connecteurs de matériau conducteur, un connecteur assurant une liaison électrique entre une première charge ohmique, un segment de grille associé à une seconde grille abaisseuse de tension et un premier noeud commun partagé par un premier transistor abaisseur de tension et un premier transistor porte d'accès, et l'autre connecteur assurant une liaison électrique entre une seconde charge ohmique, un segment de grille associé à une première grille abaisseuse de tension et un second noeud commun partagé par un second transistor abaisseur de tension et un second transistor porte d'accès.

19. Un procédé selon la revendication 18, caractérisé par la formation dudit matériau conducteur essentiellement en polysilicium dopé, dopé avec le même type de conductivité que ladite zone dopée, ou du tungstène.

**Patentansprüche**

1. Statische RAM-Speicherzelle mit vier Transistoren, die auf einem Halbleitersubstrat ausgebildet ist und zwei Durchgangsgattertransistoren und ein Flipflop mit zwei Pull-Down-Transistoren aufweist, wobei der erste Durchgangsgattertransistor (12) mit dem ersten Pull-Down-Transistor (18) über einen Diffusionsbereich (80) verbunden ist, dadurch gekennzeichnet, daß der zweite Durchgangsgattertransistor (14) mit dem zweiten Pull-Down-Transistor (20) ebenfalls über einen Diffusionsbereich verbunden ist, daß das eine Paar aus Durchgangsgatter- und Pull-Down-Transistor (12, 18) um 180° gedreht und neben dem anderen Paar aus Durchgangsgatter- und Pull-Down-Transistor (14, 20) angeordnet ist, daß die Gatter der Pull-Down-Transistoren (18, 20) aus einer ersten Gatterschicht (52b, 52a) gebildet sind, und daß die Gatter der Durchgangsgattertransistoren (12, 14) aus einer zweiten, von der ersten Schicht (52b, 52a) verschiedenen Gatterschicht (56) gebildet sind.

2. Speicherzelle nach Anspruch 1, dadurch gekennzeichnet, daß die Gatter der Durchgangsgattertransistoren (12, 14) eine erste Dicke und die Gatter der Pull-Down-Transistoren (18, 20) eine zweite, unabhängige Dicke aufweisen.

3. Speicherzelle nach Anspruch 1 oder 2, dadurch gekennzeichnet, daß der erste Durchgangsgattertransistor (12) mit dem ersten Pull-Down-Transistor (18) in Reihe geschaltet ist, wobei der erste Durchgangsgattertransistor (12) und der erste Pull-Down-Transistor (18) einen ersten gemeinsamen Knoten (26) aufweisen, und der zweite Durchgangsgattertransistor (14) mit dem zweiten Pull-Down-Transistor (20) in Reihe geschaltet ist, wobei der zweite Durchgangsgattertransistor (14) und der zweite Pull-Down-Transistor (20) einen zweiten gemeinsamen Knoten (30) aufweisen.

4. Speicherzelle nach Anspruch 3, dadurch gekennzeichnet, daß das Gatter des ersten Pull-Down-Transistors (18) ein integraler Bestandteil eines größeren ersten Pull-Down-Gattersegments (52b) ist, und daß das Gatter des zweiten Pull-Down-Transistors (20) ein integraler Bestandteil eines größeren zweiten Pull-Down-Gattersegments (52a) ist, wobei das erste Pull-Down-Gattersegment zu dem zweiten gemeinsamen Knoten (30) geführt und über diesem angeordnet ist, und wobei das zweite Pull-Down-Gattersegment zu dem ersten gemeinsamen Knoten (26) geführt und über diesem angeordnet ist.

5. Speicherzelle nach Anspruch 4, dadurch gekennzeichnet, daß beide Gatter der Durchgangsgattertransistoren (12, 14) miteinander durch ein Verbindungssegment (56) verbunden sind, das gleiche, zur Bildung der Gatter der Durchgangsgattertransistoren verwendete Material aufweist, wodurch ein durchgehender Streifen gebildet ist, der als Wortleitung (16) dient und wobei die Wortleitung das erste und das zweite Pull-Down-Gattersegment (52a, 52b) kreuzt.

6. Speicherzelle nach Anspruch 5, dadurch gekennzeichnet, daß zwei Anschlußkontakte (58, 60) vorgesehen sind, von denen einer eine elektrische Verbindung zwischen dem ersten gemeinsamen Knoten (26), dem zweiten Pull-Down-Gattersegment (52a) und einer ersten Widerstandslast (88) bildet, und der andere eine elektrische Verbindung zwischen dem zweiten gemeinsamen Knoten (30), dem ersten Pull-Down-Gattersegment (52b) und einer zweiten Widerstandslast bildet.

7. Speicherzelle nach einem der Ansprüche 1-6, dadurch gekennzeichnet, daß die Gatterschichten Polysilizium enthalten.

8. Speicherzelle nach einem der Ansprüche 1-6, dadurch gekennzeichnet, daß die Gatterschichten ein schwerschmelzendes Metall enthalten.

9. Speicherzelle nach Anspruch 8, dadurch gekennzeichnet, daß das schwerschmelzende Metall Molybden oder Wolfram enthält.

10. Speicherzelle nach einem der Ansprüche 1-6, dadurch gekennzeichnet, daß die Gatterschichten eine auf einer Polysiliziumschicht ausgebildete Schicht aus schwerschmelzendem Metall-Silizid aufweisen.

11. Speicherzelle nach Anspruch 10, dadurch gekennzeichnet, daß das schwerschmelzende Metall-Silizid Molybden, Wolfram, Titan oder Tantal enthält.

12. Speicherzelle nach einem der Ansprüche 1-11, dadurch gekennzeichnet, daß die Gatteroxiddicke der Pull-Down-Transistoren zwischen ungefähr 125 und 250 Å liegt.

13. Speicherzelle nach Anspruch 12, dadurch gekennzeichnet, daß die Gatteroxiddicke zwischen ungefähr 125 und 150 Å liegt.

14. Speicherzelle nach einem der Ansprüche 1-11, dadurch gekennzeichnet, daß die Gatteroxiddicke der Durchgangsgattertransistoren zwischen ungefähr 200 und 400 Å liegt.

15. Speicherzelle nach Anspruch 14, dadurch gekennzeichnet, daß die Gatteroxiddicke zwischen ungefähr 200 und 250 Å liegt.

16. Verfahren zur Herstellung einer symmetrischen statischen RAM-Speicherzelle mit vier Transistoren, die zwei Durchgangsgattertransistoren und ein Fliplflop mit zwei Pull-Down-Transistoren umfassen, wobei die Transistoren jedes Transistorpaares ein Gatter aufweisen, das über einem Gatteroxid liegt, welches über einem Kanalbereich und zwei den Kanalbereich flankierenden dotierten Bereichen ausgebildet ist, wobei ein erster Durchgangsgattertransistor (12) einen Diffusionsbereich (80) aufweist, über den eine Verbindung mit einem ersten Pull-Down-Transistor (18) hergestellt wird, gekennzeichnet durch das Bilden eines zweiten Durchgangsgattertransistors (14) mit einem weiteren Diffusionsbereich, über den eine Verbindung zu einem zweiten Pull-Down-Transistor (20) hergestellt wird, das Anordnen des ersten und des zweiten Durchgangsgattertransistors sowie des ersten und des zweiten Pull-Down-Transistors in symmetrischer Anordnung, wobei das eine Durchgangsgatter-/Pull-Down-Transistorpaar (12, 18) um 180° verschoben und neben dem anderen Durchgangsgatter-/Pull-Down-Transistorpaar (14, 20) angeordnet wird, wobei die Gatter der Pull-Down-Transistoren (18, 20) aus einer ersten Gatterschicht (52b, 52a) und die Gatter der Durchgangsgattertransistoren (12, 14) aus einer zweiten, von der ersten Gatterschicht (52b, 52a) verschiedenen Gatterschicht (50) gebildet sind.

17. Verfahren nach Anspruch 16, gekennzeichnet durch das Bilden strukturierter, in geeigneter Weise dotierter Lastbereiche mit hohem Widerstand und Verbindungsbereiche mit geringem Widerstand in einer Polysiliziumschicht, die von jeder der Gatterschichten verschieden ist.

18. Verfahren nach Anspruch 17, gekennzeichnet durch das Bilden zweier Anschlüsse aus leitendem Material in einer Zelle, von denen ein Anschluß eine elektrische Verbindung zwischen einer ersten Widerstandslast, einem zu einem zweiten Pull-Down-Gatter gehörenden Gattersegment und einem ersten, einem ersten Pull-Down-Transistor und einem ersten Durchgangsgattertransistor gemeinsamen Knoten bildet, und der andere Anschluß eine elektrische Verbindung zwischen einer zweiten Widerstandslast, einem zu einem ersten Pull-Down-Gatter gehörenden Gattersegment und einem zweiten, einem zweiten Pull-Down-Transistor und einem zweiten Durchgangsgattertransistor gemeinsamen Knoten bildet.

19. Verfahren nach Anspruch 18, gekennzeichnet durch das Bilden des leitenden Materials im wesentlichen aus dotiertem Polysilizium, das mit dem gleichen Leitfähigkeitstyp dotiert ist, wie der dotierte Bereich, oder aus Wolfram.

1/3

FIG. 1

FIG. 2

FIG. 3

FIG. 4A

FIG. 4B

FIG. 4C

FIG. 4D

FIG. 4E

FIG. 4F